(19) **Europäisches Patentamt / European Patent Office / Office européen des brevets**

(11) **EP 2 808 368 B1**

(12) **EUROPEAN PATENT SPECIFICATION**

(45) Date of publication and mention
of the grant of the patent:
**21.06.2017 Bulletin 2017/25**

(21) Application number: **13740897.7**

(22) Date of filing: **23.01.2013**

(51) Int Cl.:
*C09D 201/00* (2006.01)    *C09D 5/02* (2006.01)
*C09D 5/16* (2006.01)    *C09D 7/12* (2006.01)
*C09D 143/04* (2006.01)    *C09D 183/04* (2006.01)
*G02B 1/11* (2015.01)    *H01L 31/052* (2014.01)
*H02S 40/20* (2014.01)

(86) International application number:
**PCT/JP2013/051330**

(87) International publication number:
**WO 2013/111783 (01.08.2013 Gazette 2013/31)**

(54) **COATING COMPOSITION AND ANTIREFLECTION FILM**

BESCHICHTUNGSZUSAMMENSETZUNG UND ANTIREFLEXIONSFILM

COMPOSITION DE REVÊTEMENT ET FILM ANTI-REFLET

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **23.01.2012 JP 2012011122**

(43) Date of publication of application:
**03.12.2014 Bulletin 2014/49**

(73) Proprietor: **ASAHI KASEI KABUSHIKI KAISHA
Chiyoda-ku
Tokyo (JP)**

(72) Inventors:
• **SHIRAISHI, Kentaro
Tokyo 101-8101 (JP)**

• **TAKANOHASHI, Hiroaki
Tokyo 101-8101 (JP)**

(74) Representative: **Strehl Schübel-Hopf & Partner
Maximilianstrasse 54
80538 München (DE)**

(56) References cited:
WO-A1-2010/104146    JP-A- 2005 010 470
JP-A- 2005 010 470    JP-A- 2006 001 974
JP-A- 2010 235 676    JP-A- 2010 235 676
JP-A- 2010 237 279    JP-A- 2011 111 533
US-A1- 2011 123 708

## Description

Technical Field

The present invention relates to a coating composition and an antireflection film.

Background Art

Many of antireflection films are manufactured through a first step of fabricating a coating film, and a second step of forming voids. By once forming a coating film and thereafter fabricating voids in the coating film in such a way, the antireflection film is caused to be decreased in the refractive index of the coating film and decreased in the reflectance thereof.

For example, Patent Documents 1 to 4 study porous bodies which is formed by introducing voids into films by using porosity-causing agents. However, problems of these porous bodies are that when a porosity-causing agent is removed in an extraction step in a second step of forming voids, films swell to cause the appearance faults of the voids and the exfoliation, and that a film-formation step is complicated.

Then, for example, Patent Documents 5 to 7 study a method of forming a porous body film having a low refractive index without extraction operation, specifically, a method of forming a porous body film by using a coating liquid containing a chain metal oxide.

Further Patent Documents 8 and 10 also disclose antireflection films which is obtained by using a coating liquid containing a chain silica sol and a spherical microparticle and is excellent in the scratch resistance.

On the other hand, Patent Document 9 discloses a coating film which is excellent in the mechanical strength, transparency, weather resistance, chemical resistance, optical property and further the antifouling property, antifogging property, antistatic property and the like, and is formed by using an aqueous polymer dispersion.

Further Patent Document 11 states a coating composition excellent in the antifouling performance.

List of Prior Art Documents

Patent Document

Patent Document 1: Japanese Patent Laid-Open No. 01-312501
Patent Document 2: Japanese Patent Laid-Open No. 07-140303
Patent Document 3: Japanese Patent Laid-Open No. 03-199043
Patent Document 4: Japanese Patent Laid-Open No. 11-035313
Patent Document 5 Japanese Patent Laid-Open No. 2001-188104
Patent Document 6: Japanese Patent Laid-Open No. 11-061043
Patent Document 7: Japanese Patent Laid-Open No. 11-292568
Patent Document 8: Japanese Patent Laid-Open No. 2005-10470
Patent Document 9: International Publication No. WO2007/069596
Patent Document 10: National Publication of International Patent Application No. 2011-530401
Patent Document 11: International Publication No. WO2010/104146
Patent Document 12: US 2011/123708 A1

Summary of Invention

Problems to be Solved by Invention

However, porous bodies obtained by the methods disclosed in Patent Documents 5 to 7 have the problem of being poor in the mechanical strength. The antireflection films disclosed in Patent Documents 8 and 10 have room for improvement in the weather resistance. Further the coating film disclosed in Patent Document 9 has room for improvement in the antireflection property. Still further the coating composition disclosed in Patent Document 11 has room for improvement in the antireflection property. The antireflection films disclosed in Patent Document 12 have room for improvement concerning the balance of antireflective and mechanical properties.

It is known that solar cells comprising an antireflection film generally have the following peculiar problem: alkali components dissolve out from the glass interior in a high-humidity environment. It causes a problem of being poor in the weather resistance, and specifically, the dissolving substances infiltrate in voids of the antireflection film to cause a decrease in the antireflection effect in a long-period environmental exposure.

Then, an object of the present invention is to easily form an antireflection film excellent in the antireflection property, mechanical strength, weather resistance and antifouling property.

Means for Solving Problems

As a result of exhaustive studies to solve the above-mentioned problems, the present inventors have found that a coating film excellent in the antireflection property and mechanical strength can be easily formed by using a coating composition obtained by a mixing metal oxide (A) containing a spherical metal oxide (a1) and a chain metal oxide (a2) having an aspect ratio (major diameter/minor diameter) of 3 to 25 with a polymer emulsion particle (B), and that the coating film has also an excellent antifouling performance and a high weather resistance; and these findings have led to the completion of the present invention.

That is, the present invention is as follows.

[1] A coating composition, comprising:

a metal oxide (A) containing a spherical metal oxide (a1) and a chain metal oxide (a2) having an aspect ratio (major diameter/minor diameter) of 3 to 25; and

a polymer emulsion particle (B), wherein the spherical metal oxide (a1) has an average particle diameter of 1 to 50 nm; and the weight ratio of the spherical metal oxide (a1) and the chain metal oxide (a2) ((a1):(a2)) is 1:3 to 1:20.

[2] The coating composition according to [1], further comprising a hydrolyzable silicon compound (C).

[3] The chain metal oxide (a2) has an average major diameter of 20 to 250 nm.

[4] The coating composition according to any of [2] or [3], wherein the weight ratio of the metal oxide (A) and the polymer emulsion particle (B) ((A):(B)) is 1:0.05 to 1:1; and the weight ratio of the metal oxide (A) and the hydrolyzable silicon compound (C) ((A):(C)) is 1:0.05 to 1:0.5.

[5] The coating composition according to any of [1] to [4], wherein the polymer emulsion particle (B) is obtained by polymerizing a hydrolyzable silicon compound (b1) and a vinyl monomer (b2) having a secondary and/or tertiary amido group in the presence of water and an emulsifying agent.

[6] An antireflection film, being obtained by applying and drying the coating composition according to any of [1] to [5] on a substrate.

[7] The antireflection film according to [6] comprising polymer particle (B'), wherein the polymer particles (B') themselves are present in no direct contact with one another.

[8] The antireflection film according to [7], wherein the antireflection film has a structural body in which the chain metal oxide (a2) is bonded directly, and/or through the spherical metal oxide (a1), to a surface of the polymer particle (B').

[9] The antireflection film according to [7] or [8], further comprising a hydrolytic condensation product (C') of a hydrolyzable silicon compound (C), wherein the antireflection film has a structural body in which the hydrolytic condensation product (C') of the hydrolyzable silicon compound (C) is bonded to a surface of the polymer particle (B'); and further, the chain metal oxide (a2) is bonded directly, and/or through the spherical metal oxide (a1), to a surface of the polymer particle (B').

[10] The antireflection film according to any of [7] to [9], wherein the polymer particle (B') has at least one hydrogen-bondable functional group selected from the group consisting of an amido group, an ether group, a hydroxyl group, a thiol group and a carbonyl group; and

the antireflection film has a structural body in which the chain metal oxide (a2) is bonded to the hydrogen-bondable functional group of the polymer particle (B').

[11] The antireflection film according to any of [7] to [10], wherein the antireflection film is formed on a substrate; and the metal oxide (A) and/or the hydrolytic condensation product (C') of the hydrolyzable silicon compound (C) is bonded directly to the substrate.

[12] The antireflection film according to any of [7] to [11], wherein the antireflection film has a contact angle with water of 40° or smaller.

[13] The antireflection film according to any of [7] to [12], wherein the antireflection film has a surface resistance of $1.0 \times 10^{14}$ Ω or lower, the surface resistance being measured at an applied voltage of 200 V after the antireflection film is left in an air-conditioned room at a temperature of $20 \pm 2$°C and at a relative humidity of $50 \pm 5$% for 16 hours or longer.

[14] A method for manufacturing a coating composition, comprising:

EP 2 808 368 B1

a first step of blending a metal oxide (A) containing a spherical metal oxide (a1) and a chain metal oxide (a2) having an aspect ratio of 3 to 25, and a polymer emulsion particle (B) to thereby obtain a mixture; and a second step of adding an acid to the mixture obtained in the first step, wherein the spherical metal oxide (a1) has an average particle diameter of 1 to 50 nm; and the weight ratio of the spherical metal oxide (a1) and the chain metal oxide (a2) ((a1):(a2)) is 1:3 to 1:20.

[15] A glass for a solar cell, comprising the antireflection film according to any of [6] to [13].

[16] A module for a solar cell, comprising the antireflection film according to any of [6] to [13].

[17] A condenser lens for a solar cell, comprising the antireflection film according to any of [6] to [13].

Advantages of Invention

The use of the coating composition according to the present invention allows simply manufacturing a film (for example, an antireflection film and an antifouling coat) excellent in the antireflection property, mechanical strength, weather resistance and antifouling performance through no complicated steps.

Mode for Carrying Out Invention

Hereinafter, embodiments to carry out the present invention (hereinafter, simply referred to as "the present embodiment") will be described in detail. The following present embodiment illustrates the present invention, and is not intended to limit the present invention to the following content. The present invention can be carried out under suitable modifications and changes within the gist.

<<Coating composition>>

A coating composition according to the present embodiment comprises metal oxides (A) containing a spherical metal oxide (a1) and a chain metal oxide (a2) having an aspect ratio (major diameter/minor diameter) of 3 to 25, and polymer emulsion particles (B).

In the coating composition according to the present embodiment, it is conceivable that the incorporation of the chain metal oxide (a2) and the polymer emulsion particles (B) brings about the heteroaggregation of the chain metal oxide (a2) and the polymer emulsion particle (B) or the aggregation of the chain metal oxides (a2) themselves, thereby to forms voids among particles. A coating film obtained from the coating composition according to the present embodiment conceivably has voids formed thereby. Further in the coating composition according to the present embodiment, the incorporation of the spherical metal oxide (a1) and the chain metal oxide (a2) increases adhesive points among particles as compared with a coating composition containing a chain metal oxide (a2) alone. Therefore, a coating film obtained from the coating composition according to the present embodiment conceivably has an increased mechanical strength.

The coating composition according to the present embodiment preferably further comprises a hydrolyzable silicon compound (C). In the coating composition according to the present embodiment in the case of comprising a hydrolyzable silicon compound (C), it is conceivable that bonds are formed by the condensation reaction between silanol groups of the hydrolyzable silicon compound (C) and hydroxyl groups present on the surface of the metal oxides (A), or hydrogen bonds are formed between the hydrolyzable silicon compound (C) and the metal oxides (A). It is conceivable that a coating film obtained from the coating composition according to the present embodiment thereby has a more increased mechanical strength.

Additionally, a coating film formed from the coating composition according to the present embodiment, since having the surface hydrophilicity caused by the metal oxides (A) and the hydrolyzable silicon compound (C), conceivably has an antifouling effect. That is, it is conceivable that in the coating film formed from the coating composition according to the present embodiment, since the coating film has the surface hydrophilicity, an antistatic effect thereof reduces the adhesion of fouling such as sands and dusts, and the fouling is washed away by rain water even in the case of fouling adhesion. However, the mechanism is not limited thereto.

<Metal oxides (A)>

Metal oxides (A) used in the present embodiment contain a spherical metal oxide (a1) and a chain metal oxide (a2) having an aspect ratio (major diameter/minor diameter) of 3 to 25.

Here, the spherical metal oxide refers to a metal oxide present in a particulate form having an aspect ratio (major diameter/minor diameter) of lower than 3. The aspect ratio refers, in the case where particles are present as primary ones as they are, to an aspect ratio of the primary particles, and in the case where particles are present as aggregated particles, to an aspect ratio of the aggregated particles.

The presence form of the spherical metal oxide (a1) may be primary particles or may be aggregated particles. In the case of being aggregated particles, the shape does not need to be a complete sphere, and may have, for example, edges.

Here, the aspect ratio of a spherical metal oxide (a1) and a chain metal oxide (a2) can be determined by obtaining a major diameter/minor diameter from measurement values acquired by measuring the minor diameter and the major diameter of the metal oxide particle photographed using a transmission electron microscope (TEM). Here, the minor diameter and the major diameter are a short side and a long side, respectively, of a rectangle circumscribing the metal oxide particle and making a smallest area.

The spherical metal oxide (a1) is not especially limited, but examples thereof include oxides of silicon, aluminum, titanium, zirconium, zinc, tin, indium, gallium, germanium, antimony and molybdenum.

The average particle diameter of the spherical metal oxide (a1) is, from the viewpoint of the development of the transparency and the mechanical strength, 1 to 50 nm, and still more preferably 1 to 10 nm. Here, the average particle diameter refers, in the case where particles are present in a primary particle shape, to a primary particle diameter, and in the case where particles are present in an aggregated particle shape, to an aggregated particle diameter (secondary particle diameter), and can be determined by the following method. The average particle diameter can be determined by measuring particle diameters (biaxial average diameters, that is, average values of the minor diameter and the major diameter) of particles of the spherical metal oxide (a1) present in a transmission electron microscope (TEM) photograph taken by adjusting so as to photograph 100 to 200 particles thereof, and calculating the average value of the particle diameters measured.

The chain metal oxide refers to a metal oxide having an aspect ratio (major diameter/minor diameter) of 3 or higher, and examples thereof include composite particles formed by connecting primary particles of metal oxide (micro)particles in a rosary-like row.

The chain metal oxide (a2) is not especially limited, but examples thereof include oxides of silicon, aluminum, titanium, zirconium, zinc, tin, indium, gallium, germanium, antimony and molybdenum.

The aspect ratio (major diameter/minor diameter) of the chain metal oxide (a2) is 3 to 25, preferably 3 to 15, and more preferably 3 to 10. If particles are ones in the range of the above aspect ratio, the particles may be mixed and used.

The average major diameter of the chain metal oxide (a2) is preferably 20 to 250 nm, more preferably 30 to 150 nm, and still more preferably 40 to 100 nm.

From the viewpoint of the voidage and the refractive index of a coating film, the chain metal oxide (a2) preferably has an aspect ratio (major diameter/minor diameter) of 3 or higher, and an average major diameter of 20 nm or larger. Further from the viewpoint of the transparency and the antireflection performance, it is preferable that the aspect ratio (major diameter/minor diameter) be 25 or lower, and the average major diameter be 250 nm or smaller.

The average major diameter of the chain metal oxide (a2) can be determined by measuring major diameters of particles of the chain metal oxide (a2) present in a transmission electron microscope (TEM) photograph taken by adjusting so as to photograph 100 to 200 particles thereof, and calculating the average value of the major diameters measured.

Specific examples of a raw material to form the chain metal oxide (a2) include "Snowtex-OUP(R)", "Snowtex-UP(R)", "Snowtex-PSSO(R)" and "Snowtex-PSS(R)", all made by Nissan Chemical Industries, Ltd. This chain silica sol has a three-dimensionally curved shape.

In order to improve the mechanical strength and the antireflection effect of a coating film, the mixing ratio (weight ratio) of the spherical metal oxide (a1) and the chain metal oxide (a2) is 1:3 to 1:20, and still more preferably 1:3 to 1:10.

The coating composition according to the present embodiment may comprise, in addition to the metal oxides (a1) and (a2), a metal oxide composed of, for example, boron, phosphorus, silicon, aluminum, titanium, zirconium, zinc, tin, indium, gallium, germanium, antimony or molybdenum.

<Polymer emulsion particle (B)>

A polymer constituting polymer emulsion particles (B) is not especially limited, and examples thereof include polymers constituted of alcohol adducts of polyurethane, polyester, poly(meth)acrylate, polyvinyl acetate, polybutadiene, polyvinyl chloride, chlorinated polypropylene, polyethylene, polystyrene, a polystyrene-(meth)acrylate copolymer, a rosin derivative or a styrene-maleic anhydride copolymer, and of a polycarbonyl compound of a cellulosic resin or the like.

The polymer emulsion particles (B) used in the present embodiment are not especially limited, but are preferably polymer emulsion particles obtained by polymerizing a hydrolyzable silicon compound (b1) and a vinyl monomer (b2) having a secondary and/or tertiary amido group in the presence of water and an emulsifying agent.

The number-average particle diameter of the polymer emulsion particles (B) is not especially limited, but is preferably 10 to 800 nm.

In the present embodiment, the number-average particle diameter can be measured by a method described in Examples described later.

In the coating composition according to the present embodiment, the polymer emulsion particles (B) may be cured by making the metal oxides (A) interact with the polymer emulsion particles (B). This case is preferable because a coating film obtained from the coating composition according to the present embodiment is improved in the mechanical strength.

The interaction of the metal oxides (A) with the polymer emulsion particles (B) is not especially limited, but examples thereof include the hydrogen bond and the chemical bond. The interaction specifically includes hydrogen bonds of hydroxyl groups of the metal oxides (A) with secondary and/or tertiary amido groups of the polymer emulsion particles (B), and the condensation (chemical bond) of hydroxyl groups of the metal oxides (A) with a polymer product of a hydrolyzable metal compound constituting the polymer emulsion particles (B).

The hydrolyzable silicon compound (b1) used in the case where polymer emulsion particles (B) are manufactured by polymerizing the hydrolyzable silicon compound (b1) and the vinyl monomer (b2) having a secondary and/or tertiary amido group in the presence of water and an emulsifying agent is not especially limited, and examples thereof include compounds represented by the following formula (1), condensation products thereof, and silane coupling agents.

$$SiW_xR_y \cdots (1)$$

wherein W represents at least one group selected from alkoxy groups having 1 to 20 carbon atoms, a hydroxyl group, acetoxy groups having 1 to 20 carbon atoms, halogen atoms, a hydrogen atom, oxime groups having 1 to 20 carbon atoms, an enoxy group, an aminoxy group and an amido group; R represents at least one hydrocarbon group selected from straight-chain or branched-chain alkyl groups having 1 to 30 carbon atoms, cycloalkyl groups having 5 to 20 carbon atoms and aryl groups having 6 to 20 carbon atoms which may be nonsubstituted or substituted with an alkyl group having 1 to 20 carbon atoms, an alkoxy group having 1 to 20 carbon atoms, or a halogen atom; and x is an integer of 1 or more and 4 or less, y is an integer of 0 or more and 3 or less, and x + y = 4.

The silane coupling agent is a hydrolyzable silicon compound in whose molecule a functional group is present which has the reactivity with an organic substance having a vinyl polymerizable group, an epoxy group, an amino group, a methacryl group, a mercapto group, an isocyanate group or the like.

Specific examples of the hydrolyzable silicon compound (b1) are not especially limited, but include tetraalkoxysilanes such as tetramethoxysilane, tetraethoxysilane, tetra-n-propoxysilane, tetraisopropoxysilane and tetra-n-butoxysilane; trialkoxysilanes such as methyltrimethoxysilane, methyltriethoxysilane, ethyltrimethoxysilane, ethyltriethoxysilane, n-propyltrimethoxysilane, n-propyltriethoxysilane, isopropyltrimethoxysilane, isopropyltriethoxysilane, n-butyltrimethoxysilane, n-butyltriethoxysilane, n-pentyltrimethoxy silane, n-hexyltrimethoxysilane, n-heptyltrimethoxy silane, n-octyltrimethoxysilane, vinyltrimethoxysilane, vinyltriethoxysilane, allyltrimethoxysilane, cyclohexyltrimethoxysilane, cyclohexyltriethoxysilane, phenyltrimethoxysilane, phenyltriethoxysilane, 3-chloropropyltrimethoxysilane, 3-chloropropyltriethoxysilane, 3,3,3-trifluoropropyltrimethoxysilane, 3,3,3-trifluoropropyltriethoxysilane, 3-aminopropyltrimethoxysilane, 3-aminopropyltriethoxysilane, 2-hydroxyethyltrimethoxysilane, 2-hydroxyethyltriethoxysilane, 2-hydroxypropyltrimethoxysilane, 2-hydroxypropyltriethoxysilane, 3-hydroxypropyltrimethoxysilane, 3-hydroxypropyltriethoxysilane, 3-mercaptopropyltrimethoxysilane, 3-mercaptopropyltriethoxysilane, 3-isocyanate propyltrimethoxysilane, 3-isocyanate propyltriethoxysilane, 3-glycidoxypropyltrimethoxysilane, 3-glycidoxypropyltriethoxysilane, 2-(3,4-epoxycyclohexyl)ethyltrimethoxysilane, 2-(3,4-epoxycyclohexyl)ethyltriethoxysilane, 3-(meth)acryloxypropyltrimethoxysilane, 3-(meth)acryloxypropyltriethoxysilane, 3-(meth)acryloyloxypropyltri-n-propoxysilane, 3-(meth)acryloyloxypropyltriisopropoxysilane, 3-ureidopropyltrimethoxysilane and 3-ureidopropyltriethoxysilane; dialkoxysilanes such as dimethyldimethoxysilane, dimethyldiethoxysilane, diethyldimethoxysilane, diethyldiethoxysilane, di-n-propyldimethoxysilane, di-n-propyldiethoxysilane, diisopropyldimethoxysilane, diisopropyldiethoxysilane, di-n-butyldimethoxysilane, di-n-butyldiethoxysilane, din-pentyldimethoxysilane, di-n-pentyldiethoxysilane, di-n-hexyldimethoxysilane, di-n-hexyldiethoxysilane, di-n-heptyldimethoxysilane, di-n-heptyldiethoxysilane, di-n-octyldimethoxysilane, di-n-octyldiethoxysilane, di-n-cyclohexyldimethoxysilane, di-n-cyclohexyldiethoxysilane, diphenyldimethoxysilane, diphenyldiethoxysilane and 3-(meth)acryloyloxypropylmethyldimethoxysilane; and monoalkoxysilanes such as trimethylmethoxysilane and trimethylethoxysilane.

These hydrolyzable silicon compounds (b1) can be used singly or as a mixture of two or more.

When the hydrolyzable silicon compound (b1) is used as a condensation product, the weight-average molecular weight in terms of polystyrene of the condensation product by GPC measurement is preferably 200 to 5,000, and more preferably 300 to 1,000.

Among the above-mentioned hydrolyzable silicon compounds (b1), silicon alkoxides having a phenyl group, for example, phenyltrimethoxysilane, phenyltriethoxysilane and diphenyldimethoxysilane, are preferable because of being excellent in the polymerization stability in the presence of water and an emulsifying agent.

Among the above-mentioned hydrolyzable silicon compounds (b1), silane coupling agents allowing production of chemical bonds by being copolymerized or chain transfer-reacted with the above-mentioned vinyl monomer (b2) having a secondary and/or tertiary amido group are silane coupling agents having a vinyl polymerizable group such as 3-(meth)acryloxypropyltrimethoxysilane, 3-(meth)acryloxypropyltriethoxysilane, 3-(meth)acryloyloxypropylmethyldimethoxysilane, 3-(meth)acryloyloxypropyltri-n-propoxysilane, 3-(meth)acryloyloxypropyltriisopropoxysilane, vinyltrimethoxysilane, vinyltriethoxysilane, allyltrimethoxysilane and 2-trimethoxysilylethyl vinyl ether, and silane coupling agents having a thiol group such as 3-mercaptopropyltrimethoxysilane and 3-mercaptopropyltriethoxysilane.

The amount of the hydrolyzable silicon compound (b1) used is preferably 0.005 or larger and 0.5 or smaller in terms of mass ratio (b1)/(B), which is a mass ratio of (b1) to obtained the polymer emulsion particles (B) (the total of masses (calculated values) of vinyl (co)polymers obtained in the case where vinyl monomers added ((b2) and, as the case may be, (b3) added) are all polymerized, and of a polymerization product obtained in the case where the hydrolyzable silicon compound (b1) is all polymerized).

The use of a silane coupling agent having a vinyl polymerizable group as the hydrolyzable silicon compound (b1) is preferable from the viewpoint of the weather resistance. The amount of the hydrolyzable silicon compound (b1) blended is, based on 100 parts by mass of the polymer emulsion particles (B), preferably 0.01 part by mass or larger and 20 parts by mass or smaller, and more preferably 0.1 part by mass or larger and 10 parts by mass or smaller, from the viewpoint of the polymerization stability.

The vinyl monomer (b2) having a secondary and/or tertiary amido group used for manufacture of the polymer emulsion particles (B) is not especially limited, but for example, N-alkyl or N-alkylene-substituted (meth)acrylamides can be used. Specific examples thereof include N-methylacrylamide, N-methylmethacrylamide, N-ethylacrylamide, N,N-dimethylacrylamide, N,N-dimethylmethacrylamide, N,N-diethylacrylamide, N-ethylmethacrylamide, N-methyl-N-ethylacrylamide, N-methyl-N-ethylmethacrylamide, N-isopropylacrylamide, N-n-propylacrylamide, N-isopropylmethacrylamide, N-n-propylmethacrylamide, N-methyl-N-n-propylacrylamide, N-methyl-N-isopropylacrylamide, N-acryloylpyrrolidine, N-methacryloylpyrrolidine, N-acryloylpiperidine, N-methacryloylpiperidine, N-acryloylhexahydroazepine, N-acryloylmorpholine, N-methacryloylmorpholine, N-vinylpyrrolidone, N-vinylcaprolactam, N,N'-methylenebisacrylamide, N,N'-methylenebismethacrylamide, N-vinylacetamide, diacetoneacrylamide, diacetonemethacrylamide, N-methylolacrylamide and N-methylolmethacrylamide.

The amido group of the vinyl monomer (b2) used for manufacture of the polymer emulsion particles (B) may be either of secondary and tertiary, but the use of a vinyl monomer having a tertiary amido group is preferable because the property of hydrogen bonds between obtained the polymer emulsion particles (B) with the metal oxides (A) is enhanced. Among these, especially N,N-diethylacrylamide is more preferable because of being very excellent in the polymerization stability in the presence of water and an emulsifying agent, and allowing formation of firm hydrogen bonds with hydroxyl groups of a polymerization product of the above-mentioned hydrolyzable silicon compound (b1) and hydroxyl groups of the metal oxides (A).

As the hydrolyzable silicon compound (b1), a silane coupling agent having a vinyl polymerizable group or a thiol group can be used singly, or used by being mixed or combined with a silane coupling agent such as the above-mentioned silicon alkoxide, another silane coupling agent and a condensation product thereof.

The polymerization product of the hydrolyzable silicon compound (b1) and the polymerization product of the vinyl monomer (b2) having the secondary and/or tertiary amido group constituting the polymer emulsion particles (B) may be combined through hydrogen bonds and chemical bonds. In the present embodiment, although it is preferable that the above-mentioned (b1), (b2) and the like be combined through various types of bonds such as hydrogen bonds and chemical bonds, the form, condition and the like of the bonds are not any more limited. Further in the present embodiment, for example, only a part of the polymer emulsion particles (B) may be combined as described above.

The use of the polymer emulsion particles (B) obtained by polymerizing the hydrolyzable silicon compound (b1) being a silane coupling agent having a vinyl polymerizable group or a thiol group and the vinyl monomer (b2) having the secondary and/or tertiary amido group is more preferable because of allowing formation of a coating film better in the weather resistance, chemical resistance, optical property, strength and the like.

The amount of the silane coupling agent having the vinyl polymerizable group or the thiol group blended is, based on 100 parts by mass of the vinyl monomer (b2) having the secondary and/or tertiary amido group, preferably 0.1 part by mass or larger and 100 parts by mass or smaller from the viewpoint of the polymerization stability, and is more preferably 0.5 part by mass or larger and 50 parts by mass or smaller.

It is preferable to carry out the polymerization of the vinyl monomer (b2) having the secondary and/or tertiary amido group together with another vinyl monomer (b3) copolymerizable therewith because of allowing more effective control of properties (glass transition temperature, molecular weight, hydrogen bond force, polarity, dispersion stability, weather resistance, compatibility with the polymerization product of the hydrolyzable silicon compound (b1), and the like) of a produced polymerization product.

The vinyl monomer (b3) is not especially limited, and examples thereof include (meth)acrylate esters, aromatic vinyl compounds, cyanidated vinyl compounds, and additionally, monomers containing a functional group such as carboxyl group-containing vinyl monomers, hydroxyl group-containing vinyl monomers, epoxy group-containing vinyl monomers and carbonyl group-containing vinyl monomers.

The (meth)acrylate esters are not especially limited, and examples thereof include alkyl (meth)acrylates whose alkyl moiety has 1 to 50 carbon atoms, and (poly)oxyethylene di(meth)acrylates whose number of ethylene oxide groups is 1 to 100.

Specific examples of the (meth)acrylate ester include methyl (meth)acrylate, ethyl (meth)acrylate, n-butyl (meth)acrylate, 2-ethylhexyl (meth)acrylate, methylcyclohexyl (meth)acrylate, cyclohexyl (meth)acrylate, lauryl (meth)acrylate and dodecyl (meth)acrylate.

The (poly)oxyethylene di(meth)acrylates are not especially limited, and examples thereof include ethylene glycol di(meth)acrylate, diethylene glycol di(meth)acrylate, diethylene glycol methoxy(meth)acrylate and tetraethylene glycol di(meth)acrylate.

Herein, (meth)acryl is to a simple expression of methacryl or acryl.

The amount of the (meth)acrylate ester used (in the case of using a plurality thereof, the total amount thereof) is preferably 0 to 99.9% by mass, and more preferably 5 to 80% by mass, in the whole vinyl monomer.

The aromatic vinyl compound is not especially limited, and examples thereof include styrene and vinyltoluene.

The cyanidated vinyl compound is not especially limited, and examples thereof include acrylonitrile and methacrylonitrile.

The carboxyl group-containing vinyl monomer is not especially limited, and examples thereof include (meth)acrylic acid, crotonic acid, itaconic acid, maleic acid, fumaric acid and maleic anhydride, and half esters of dibasic acids of itaconic acid, maleic acid, fumaric acid or the like. The use of a carboxyl group-containing vinyl monomer can introduce a carboxyl group to the polymer emulsion particle (B), and provides the electrostatic repulsion among particles to improve the stability as an emulsion, and allows providing a resistive power to the dispersion breaking action from the outside including aggregation in stirring. At this time, in order to more improve the electrostatic repulsion, the introduced carboxyl group may be partially or wholly neutralized with an amine such as ammonia, triethylamine or dimethylethanolamine, or a base such as NaOH or KOH.

The amount of the carboxyl group-containing vinyl monomer used (in the case of using a plurality thereof, the total amount thereof) is preferably 0 to 50% by mass in the whole vinyl monomer ((b2) + (b3)) from the viewpoint of the water resistance. The amount is more preferably 0.1 to 10% by mass, and still more preferably 0.1 to 5% by mass.

The hydroxyl group-containing vinyl monomer is not especially limited, and examples thereof include hydroxyalkyl esters of (meth)acrylic acid such as 2-hydroxyethyl(meth)acrylate, 2-hydroxypropyl (meth)acrylate, 3-hydroxypropyl (meth)acrylate, 2-hydroxybutyl (meth)acrylate, 3-hydroxybutyl (meth)acrylate and 4-hydroxybutyl (meth)acrylate; hydroxyalkyl esters of fumaric acid such as di-2-hydroxyethyl fumarate and mono-2-hydroxyethylmonobutyl fumarate; allyl alcohol and (poly)oxyethylene mono(meth)acrylates whose number of ethylene oxides is 1 to 100; (poly)oxypropylene mono(meth)acrylates whose number of propylene oxides is 1 to 100; and further "Plakcel FM, FA Monomer"(trade name of a caprolactone addition monomer, made by Daicel Chemical Industries, Ltd.), and other hydroxyalkyl esters of $\alpha,\beta$-ethylenic unsaturated carboxylic acids.

The use of the hydroxyl group-containing vinyl monomer as another vinyl monomer (b3) copolymerizable with (b2) allows easy control of the hydrogen bond force of the metal oxides (A) with the polymerization product of the vinyl monomer (b2) having the secondary and/or tertiary amido group, and allows improvement of the water dispersion stability of the polymer emulsion particles (B).

The amount of the hydroxyl group-containing vinyl monomer used is preferably 0 to 80% by mass, more preferably 0.1 to 50% by mass, and still more preferably 0.1 to 10% by mass, in the whole vinyl monomer.

The epoxy group-containing vinyl monomer is not especially limited, and examples thereof include glycidyl group-containing vinyl monomers. The glycidyl group-containing vinyl monomer is not especially limited, and examples thereof include glycidyl (meth)acrylate, allyl glycidyl ether and allyl dimethylglycidyl ether.

The carbonyl-containing vinyl monomer is not especially limited, and an example thereof includes diacetoneacrylamide.

The use of the glycidyl group-containing vinyl monomer or the carbonyl group-containing vinyl monomer as another vinyl monomer (b3) copolymerizable with (b2) makes the polymer emulsion particles (B) have a reactivity and allows forming a coating film excellent in the solvent resistance and the like by crosslinking using a hydrazine derivative, a carboxylic acid derivative, an isocyanate derivative or the like. The amount of the glycidyl group-containing vinyl monomer or the carbonyl group-containing vinyl monomer used is preferably 0 to 50% by mass in the whole vinyl monomer.

The synthesis of the polymer emulsion particles (B) may use an emulsifying agent. The emulsifying agent is not especially limited, and examples thereof include acidic emulsifying agents such as alkylbenzenesulfonic acids, alkylsulfonic acids, alkylsulfosuccinic acids, polyoxyethylene alkylsulfuric acids, polyoxyethylene alkylarylsulfuric acids and polyoxyethylene distyryl phenyl ether sulfonic acids; alkaline metal (Li, Na, K and the like) salts of acidic emulsifying agents, ammonium salts of acidic emulsifying agents and anionic surfactants of fatty acid soaps; cationic surfactants of quaternary ammonium salt, pyridinium salt and imidazolinium salt types such as alkyltrimethylammonium bromides, alkylpyridinium bromides and imidazolinium laurate; and nonionic surfactants such as polyoxyethylene alkyl aryl ethers, polyoxyethylene sorbitan fatty acid esters, polyoxyethylene oxypropylene block copolymers and polyoxyethylene distyryl phenyl ethers, and reactive emulsifying agents having a radically polymerizable double bond.

Among these emulsifying agents, the selection of reactive emulsifying agents having a radically polymerizable double bond is more preferable because the water dispersion stability of the polymer emulsion particles (B) becomes better, and a coating film excellent in the water resistance, chemical resistance, optical property, strength and the like can be formed.

The reactive emulsifying agent is not especially limited, and examples thereof include vinyl monomers having a sulfonic acid group or a sulfonate group, vinyl monomers having a sulfate ester group, and alkaline metal salts or ammonium salts thereof; vinyl monomers having a nonionic group such as polyoxyethylene; and vinyl monomers having a quaternary ammonium salt.

Specific examples of the salts of the vinyl monomers having the sulfonic acid group or the sulfonate group are not especially limited, and include compounds which have a radically polymerizable double bond, and have a substituent being selected from the group consisting of alkyl groups having 1 to 20 carbon atoms, alkyl ether groups having 2 to 4 carbon atoms, polyalkyl ether groups having 2 to 4 carbon atoms, aryl groups having 6 or 10 carbon atoms and a succinic acid group and being partially substituted with a group being an ammonium salt, sodium salt or potassium salt of a sulfonic acid group; and vinylsulfonate compounds having a vinyl group bonded with a group being an ammonium salt, sodium salt or potassium salt of a sulfonic acid group.

A specific example of the compound having the succinic acid group partially substituted with the group being the ammonium salt, sodium salt or potassium slat of the sulfonic acid group is not especially limited, and includes allylsulfosuccinic acid salts. Commercially available products may be used for these, and are not especially limited; and examples thereof include Eleminol JS-2 (trade name)(made by Sanyo Chemical Industries, Ltd.), and Latemul S-120, S-180A or S-180 (trade name)(made by Kao Corp.).

Specific examples of the compounds having the alkyl ether group having 2 to 4 carbon atoms or the polyalkyl ether group having 2 to 4 carbon atoms partially substituted with the group being the ammonium salt, sodium salt or potassium salt of the sulfonic acid group are not especially limited, and include Aquaron HS-10 or KH-1025 (trade name)(made by Dai-ichi Kogyo Seiyaku Co., Ltd.), and Adeka Reasoap SE-1025N or SR-1025 (trade name)(made by Adeka Corp.).

Specific examples of the vinyl monomer having the nonionic group are not especially limited, and include $\alpha$-[1-[(allyloxy)methyl]-2-(nonylphenoxy)ethyl]-$\omega$-hydroxypolyoxyethylene (trade name: Adeka Reasoap NE-20, NE-30, NE-40 or the like, made by Adeka Corp.), and a polyoxyethylene alkylpropenyl phenyl ether (trade name: Aquaron RN-10, RN-20, RN-30, RN-50 or the like, made by Dai-ichi Kogyo Seiyaku Co., Ltd.).

The amount of the emulsifying agent used is, based on 100 parts by mass of an obtained polymer emulsion particles (B), preferably in the range of being 10 parts by mass or smaller, and more preferably in the range of being 0.001 to 5 parts by mass.

The polymerization of the hydrolyzable silicon compound (b1) and the vinyl monomer (b2) having the secondary and/or tertiary amido group is carried out preferably in the presence of a polymerization catalyst.

A polymerization catalyst for the hydrolyzable silicon compound (b1) can suitably be selected depending on the component and the like of a monomer to be used for the polymerization, and is not especially limited; but examples thereof include halogenated hydrogens such as hydrochloric acid and hydrofluoric acid; carboxylic acids such as acetic acid, trichloroacetic acid, trifluoroacetic acid and lactic acid; sulfonic acids such as sulfuric acid and p-toluenesulfonic acid; acidic emulsifying agents such as alkylbenzenesulfonic acids, alkylsulfonic acids, alkylsulfosuccinic acids, polyoxyethylene alkylsulfuric acids, polyoxyethylene alkylarylsulfuric acids and polyoxyethylene distyryl phenyl ether sulfonic acids; acidic or weak acidic inorganic salts, and acidic compounds such as phthalic acid, phosphoric acid and nitric acid; basic compounds such as sodium hydroxide, potassium hydroxide, sodium methylate, sodium acetate, tetramethylammonium chloride, tetramethylammonium hydroxide, tributylamine, diazabicycloundecene, ethylenediamine, diethylenetriamine, ethanolamines, $\gamma$-aminopropyltrimethoxysilane and $\gamma$-(2-aminoethyl)-aminopropyltrimethoxysilane; and tin compounds such as dibutyltin octylate and dibutyltin dilaurate. Among these, from the viewpoint of having the actions not only as a polymerization catalyst but also as an emulsifying agent, acidic emulsifying agents are preferable, and alkylbenzenesulfonic acids having 5 to 30 carbon atoms are more preferable.

As a polymerization catalyst for the vinyl monomer (b2) having the secondary and/or tertiary amido group, radically polymerizing catalysts causing the addition polymerization of vinyl monomers by radical decomposition by heat or a reducing substance are suitable, and for example, water-soluble or oil-soluble persulfate salts, peroxides and azobis compounds are used. Specific examples of the polymerization catalyst are not especially limited, but include potassium persulfate, sodium persulfate, ammonium persulfate, hydrogen peroxide, t-butylhydroperoxide, t-butylperoxybenzoate, 2,2-azobisisobutyronitrile, 2,2-azobis(2-diaminopropane) hydrochloride and 2,2-azobis(2,4-dimethylvaleronitrile). The blend amount of the polymerization catalyst is preferably 0.001 to 5 parts by mass based on 100 parts by mass of the whole vinyl monomer. When the promotion of the polymerization speed and the polymerization at low temperatures of 70°C or lower are desired, use of a radically polymerizing catalyst in combination with a reducing agent such as sodium bisulfite, ferrous chloride, ascorbate salts and Rongalit is advantageous.

As described above, the polymer emulsion particles (B) can be obtained by polymerizing the hydrolyzable silicon compound (b1) and the vinyl monomer (b2) having the secondary and/or tertiary amido group (as required, another vinyl monomer (b3) copolymerizable therewith is used) in the presence of water and the emulsifying agent, and preferably in the presence of the polymerization catalyst.

Although the polymerization of the hydrolyzable silicon compound (b1) and the vinyl monomer (b2) having the secondary and/or tertiary amido group can be carried out separately, simultaneous carrying-out thereof is preferable because micro organic and inorganic combining by hydrogen bonds and the like between the both can be achieved.

The number-average particle diameter of the polymer emulsion particles (B) (primary particle diameter; the number-average particle diameter of primary particles of the polymer emulsion particles (B)) is preferably 10 to 800 nm. The regulation of the particle diameter of (B) in the above range allows formation of a coating film better in the weather resistance, chemical resistance, optical property, and further the antifouling property, antifogging property, antistatic property and the like. Further from the viewpoint of improving the transparency of an obtained coating film, the number-average particle diameter of the polymer emulsion particles (B) is more preferably 50 to 300 nm.

A method for manufacturing the polymer emulsion particles (B) having such a number-average particle diameter is not especially limited, but is preferably the so-called emulsion polymerization, which polymerizes the hydrolyzable silicon compound (b1) and the vinyl monomer (b2) having the secondary and/or tertiary amido group in the presence of water in such an enough amount that the emulsifying agent forms micells.

An example of a specific method of the emulsion polymerization is not especially limited, but includes a method in which the hydrolyzable silicon compound (b1) and the vinyl monomer (b2) having the secondary and/or tertiary amido group (as required, another vinyl monomer (b3) copolymerizable therewith is used) as they are or in an emulsified state are dropped collectively, separately, or continuously into a reaction vessel, and allowed to be polymerized in the presence of the above-mentioned polymerization catalyst, preferably under a pressure from the atmospheric pressure to, as required, 10 MPa, at a reaction temperature of about 30 to 150°C. As required, the pressure and the reaction temperature may be varied. The ratio of the total amount of the hydrolyzable silicon compound (b1) and the whole vinyl monomer to water is not especially limited, but the amount of the final solid content (a value calculated from the total (calculated value) of masses of polymers (polymerization products of the vinyl (co)polymer and the hydrolyzable silicon compound (b1)) obtained in the case where the monomers added are all polymerized) is preferably so established as to be in the range of 0.1 to 70% by mass, and preferably 1 to 55% by mass.

In order to grow or control the particle diameter in the emulsion polymerization, a seed polymerization method may be used in which the polymerization is carried out by previously making emulsion particles present in a water phase. Thereby, polymer emulsion particles whose particle diameters are more uniform can be obtained. A substance to become seeds (nuclei) is not especially limited; and a well-known substance may be used, and the substance can suitably be selected depending on the reaction condition and the like. The polymerization reaction may progress in the pH range of the reaction system of preferably 1.0 to 10.0, and more preferably 1.0 to 6.0. The pH can be regulated using a pH buffer agent such as disodium phosphate, borax, sodium hydrogencarbonate or ammonia.

As a method of obtaining the polymer emulsion particles (B), a method may be employed in which the hydrolyzable silicon compound (b1) and the vinyl monomer (b2) having the secondary and/or tertiary amido group are polymerized in the presence of water and an emulsifying agent necessary for polymerizing the hydrolyzable silicon compound (b1), and as required, a solvent, and thereafter, water is added until the polymerization products become emulsions.

The polymer emulsion particles (B) are preferably those having a core/shell structure formed of two or more layers. Thereby, a coating film excellent in the mechanical properties (balance in strength and flexibility, and the like) can be obtained.

In polymer emulsion particles (B) used in the present embodiment, components usually added and blended in coating materials and molding resins can be blended according to the applications and using methods, the components being, for example, a thickener, leveling agent, thixotropic agent, defoaming agent, freezing stabilizer, delustering agent, crosslinking reaction catalyst, pigment, curing catalyst, crosslinking agent, filler, antiskinning agent, dispersant, wetting agent, light stabilizer, antioxidant, ultraviolet absorber, rheology control agent, defoaming agent, film-forming auxiliary agent, rust preventive, dye, plasticizer, lubricant, reducing agent, antiseptic, antifungal agent, deodorant, yellowing inhibitor, antistatic agent, or electrification regulator.

<Hydrolyzable silicon compound (C)>

The hydrolyzable silicon compound (C) used in the present embodiment is preferably at least one hydrolyzable silicon compound selected from the group consisting of compounds represented by the following formulae (2), (3) and (4).

```
R1nSiX4-n ··· (2)
```

wherein R1 represents a hydrogen atom, or an alkyl group, an alkenyl group, alkynyl group or aryl group which may have a halogen group, a hydroxy group, a mercapto group, an amino group, a (meth)acryloyl group or an epoxy group and which have 1 to 10 carbon atoms; X represents a hydrolyzable group; and n is an integer of 0 to 3.

```
X3Si-R2n-SiX3 ··· (3)
```

wherein X3 represents a hydrolyzable group; R2 represents an alkylene group having 1 to 6 carbon atoms or a phenylene group; and n is 0 or 1.

$$R3-(O-Si(OR3)_2)n-OR3 \quad \cdots \quad (4)$$

wherein R3 represents an alkyl group having 1 to 6 carbon atoms; and n is an integer of 2 to 8.

<Content ratios of each component>

In the coating composition according to the present embodiment, the weight ratio of the metal oxides (A) and the polymer emulsion particles (B) ((A):(B)) is preferably 1:0.05 to 1:1; and the weight ratio of the metal oxides (A) and the hydrolyzable silicon compound (C) ((A):(C)) is preferably 1:0.05 to 1:0.5.

The weight ratio of the metal oxides (A) and the polymer emulsion particles (B) ((A):(B)) is preferably 1:0.05 or more from the viewpoint of the weather resistance of a coating film. The weight ratio of the metal oxides (A) and the polymer emulsion particles (B) ((A):(B)) is preferably 1:1 or less from the viewpoint of the transparency.

The weight ratio of the metal oxides (A) and the hydrolyzable silicon compound (C) ((A):(C)) is preferably 1:0.05 or more from the viewpoint of the mechanical strength and the weather resistance. The weight ratio of the metal oxides (A) and the hydrolyzable silicon compound (C) ((A):(C)) is preferably 1:0.5 or less from the viewpoint of making the voidage high and the refractive index of a coating film low. The weight of the hydrolyzable silicon compound (C) refers to a weight in terms of $SiO_2$ after the hydrolyzable silicon compound (C) is hydrolyzed and condensed.

<Method for manufacturing coating composition>

A method for manufacturing the coating composition according to the present embodiment preferably comprises a first step of blending metal oxides (A) containing a spherical metal oxide (a1) and a chain metal oxide (a2) having an aspect ratio (major diameter/minor diameter) of 3 to 25, and polymer emulsion particles (B) to thereby obtain a mixture, and a second step of adding an acid to the mixture obtained in the first step. In the case where an acid is added as a hydrolysis and condensation catalyst, it is preferable from the viewpoint of the blend stability that the metal oxides (A) and the polymer emulsion particles (B) are first blended, and then, the acid is added.

The acid is not especially limited, but examples thereof include halogenated hydrogens such as hydrochloric acid and hydrofluoric acid; carboxylic acids such as acetic acid, trichloroacetic acid, trifluoroacetic acid and lactic acid; sulfonic acids such as sulfuric acid, methanesulfonic acid and p-toluenesulfonic acid; acidic emulsifying agents such as alkylbenzenesulfonic acids, alkylsulfonic acids, alkylsulfosuccinic acids, polyoxyethylene alkylsulfuric acids, polyoxyethylene alkylarylsulfuric acids and polyoxyethylene distyryl phenyl ether sulfonic acids; acidic or weak acidic inorganic salts, and acidic compounds such as phthalic acid, phosphoric acid and nitric acid.

<<Antireflection film>>

An antireflection film according to the present embodiment is obtained by applying and drying the above-mentioned coating composition on a substrate.

A method for applying the above-mentioned coating composition on a substrate is not especially limited, but examples thereof include a spray method, flow coating method, roll coat method, brush coating method, dip coating method, spin coating method, screen printing method, casting method, gravure printing method and flexoprinting method.

The drying method is not especially limited, but examples thereof include natural drying, hot air drying and infrared-ray drying. The drying temperature is preferably 5 to 700°C, more preferably 10 to 300°C, and still more preferably 20 to 200°C.

A coating film formed by the application is dried on the substrate, and thereafter, as desired, can be subjected to a heat treatment preferably at 20°C to 500°C, more preferably 40°C to 250°C, the ultraviolet-ray irradiation, or the like.

The thickness of the antireflection film according to the present embodiment is preferably 0.05 to 10 μm from the viewpoint of the transparency and the antireflection property. The substrate is not especially limited, but examples thereof include organic substrates such as synthetic resins and natural resins, inorganic substrates such as glass, and combinations thereof.

The antireflection film according to the present embodiment, since being excellent in the transparency and the antireflection property, can be used as an antireflection film of members needing the improvement of the light transmission and/or the prevention of the reflection, in members (glass, module and the like) for solar cells, condenser lenses for solar cells, solar cells, liquid crystal displays, eyeglasses, window glasses, televisions and the like.

The antireflection film according to the present embodiment comprises the metal oxides (A) containing the spherical metal oxide (a1) and the chain metal oxide (a2) having the aspect ratio (major diameter/minor diameter) of 3 to 25, and polymer particles (B'), wherein the polymer particles (B') themselves are present with no direct contact with one another. The polymer particles (B') are polymer particles formed by evaporation of a solvent from a polymer emulsion particles (B). Such an antireflection film is preferable because voids are formed and further the weather resistance is improved. The structure formed in an antireflection film can be observed by a transmission electron microscope (TEM) or a scanning electron microscope (SEM).

Further, the antireflection film according to the present embodiment preferably has a structural body in which a chain metal oxide (a2) is bonded directly, and/or through a spherical metal oxide (a1), to the surface of the polymer particle (B'). The antireflection film having such a structural body is good in the weather resistance because the polymer particle (B') does not contact directly with a substrate due to voids formed by the chain metal oxide (a2) and the bond by the metal oxide (a1) or (a2) to the surface of the polymer particle (B'). The antireflection film having such a structural body is improved in the mechanical strength because adhesion points among particles of the spherical metal oxide (a1) increase. Further an antireflection film having such a structural body is improved in the antistatic effect because having a surface hydrophilic group.

The antireflection film according to the present embodiment further comprises a hydrolytic condensation product (C') of a hydrolyzable silicon compound (C), and preferably has a structural body in which the hydrolytic condensation product (C') of the hydrolyzable silicon compound (C) is bonded to the surface of the polymer particle (B'), and further the chain metal oxide (a2) is bonded directly, and/or through the spherical metal oxide (a1), to the surface of the polymer particle (B'). The antireflection film further comprising the hydrolytic condensation product (C') and having such a structural body is more improved in the mechanical strength and the weather resistance.

The antireflection film according to the present embodiment, from the viewpoint of the weather resistance, chemical resistance, optical property, strength and the like, preferably contains the polymer particle (B') having at least one hydrogen-bondable functional group selected from the group consisting of an amido group, an ether group, a hydroxyl group, a thiol group and a carbonyl group; and has a structural body in which the chain metal oxide (a2) is bonded to the hydrogen-bondable functional group of the polymer particle (B'). A specific example of such a structural body is not especially limited, but includes a structural body in which in the case of using a colloidal silica (usually, silanol groups (Si-OH) are present on the surface) as a raw material of a chain metal oxide (a2), the hydroxyl group of the surface of the colloidal silica and the hydrogen-bondable functional group of the polymer particle (B') are bonded.

The antireflection film according to the present embodiment is an antireflection film formed on a substrate, wherein the metal oxides (A) and/or the hydrolytic condensation product (C') of the hydrolyzable silicon compound (C) is bonded directly to the substrate, from the viewpoint of the weather resistance.

From the viewpoint of the antifouling property, the antireflection film according to the present embodiment preferably has the contact angle with water of 40° or smaller, more preferably 30° or smaller, and still more preferably 20° or smaller. The lower the contact angle with water of the antireflection film is, the better. There are some cases where the contact angle decreases to nearly 0°. An antireflection film having a low contact angle with water has a large effect of cleaning with rain water or the like.

The antireflection film having the contact angle with water in the above range can be obtained by applying and drying the above-mentioned coating composition on a substrate.

In the present embodiment, the contact angle of the surface with water can be measured by a method described in Examples described later.

In the antireflection film according to the present embodiment, the surface resistance measured at an applied voltage of 200 V after the antireflection film is left in an air-conditioned room at a temperature of 20 ± 2°C and at a relative humidity of 50 ± 5% for 16 hours or longer is, from the viewpoint of the antifouling property by the antistatic effect, preferably $1.0 \times 10^{14}$ Ω or lower, more preferably $1.0 \times 10^{13}$ Ω or lower, and still more preferably $1.0 \times 10^{12}$ Ω or lower. An antireflection film low in the surface resistance has an antistatic effect, and dusts and the like hardly adhere thereon. The lower limit of the surface resistance of the antireflection film is not especially limited, but for example, 1.0 × 10^5 Ω or higher.

THe antireflection film having the surface resistance in the above range can be obtained by applying and drying the above-mentioned coating composition on a substrate.

In the present embodiment, the surface resistance can be measured by a method described in Examples described later.

Further, the antireflection film according to the present embodiment, since being excellent in the antifouling property, antifogging property, antistatic property, weather resistance and chemical resistance as well, can be used as an antifouling coat for mirrors for solar cells, buildings, steel structures, building materials, mortars, concretes, plastics, automobiles and the like.

Examples

The present invention will be described specifically by way of the following Examples, Synthesis Example and Comparative Examples, but these do not limit the scope of the present invention. In Examples, Synthesis Example and Comparative Examples, physical properties were measured by the following methods.

(1) Measurements of an average particle diameter, an average aspect ratio and an average major diameter

A transmission electron microscope photograph of a spherical metal oxide was taken by magnifying the image to 50,000 to 100,000 times and adjusting so as to photograph 100 to 200 spherical metal oxide particles thereof. Then, the particle diameters (average values of the major diameter and the minor diameter) of the photographed spherical metal oxide particles were measured, and the average value thereof was determined and taken as an average particle diameter.

A transmission electron microscope photograph of a chain metal oxide was taken by magnifying the image to 50,000 to 100,000 times and adjusting so as to photograph 100 to 200 chain metal oxide particles thereof. Then, the major diameter and the minor diameter of each photographed chain metal oxide particle were measured, and aspect ratios (major diameter/minor diameter) were calculated from the measurement values. An average value of the calculated aspect ratios (major diameter/minor diameter) was determined, and was taken as an average aspect ratio. The major diameters of the chain metal oxide particles having an aspect ratio (major diameter/minor diameter) in the range of 3 to 25 among the photographed chain metal oxide particles were measured; and an average thereof was determined, and taken as an average major diameter.

(2) Measurement of a reflectance

Test plates obtained in Examples and Comparative Examples were each measured for a reflection spectrum in the range of wavelengths of 300 to 800 nm by using an FE-3000 reflection spectrometer (made by Otsuka Electronics Co., Ltd.), and an average value of reflectances in the range of 450 to 650 nm was taken as an average reflectance.

(3) Measurements of a total light transmittance and a haze

Test plates obtained in Examples and Comparative Examples were each measured for a total light transmittance and a haze by a method prescribed in JIS K7361-1 by using a turbidimeter NDH2000 made by Nippon Denshoku Industries Co., Ltd. in Japan.

(4) Measurement of a pencil hardness

A pencil for test prescribed in JIS S6006 was fabricated from coating films each obtained in Examples and Comparative Examples; and a pencil hardness at a load of 1 kg was evaluated according to the evaluation method of pencil hardness prescribed in JIS K5400 by using the pencil for test.

(5) Measurement of a contact angle of a surface with water

A drop (1.0 μL) of deionized water was put on the surface of coating films each obtained in Examples and Comparative Examples, was left at 20°C for 10 sec, and thereafter measured for an initial contact angle by using a CA-X150 contact angle tester made by Kyowa Interface Science Co., Ltd. in Japan. The smaller the contact angle of a coating film with water, the higher the hydrophilicity of the film surface was evaluated as.

(6) Test of weather resistance

Test plates obtained in Examples and Comparative Examples were each subjected to a weather resistance test using an environmental tester (made by Espec Corp., SH-661) under the environment of a temperature of 85°C and a humidity of 85% and leaving the test plate therein for 200 hours. The total light transmittance of the test plate after the weather resistance test was measured as in the above (3).

(7) Measurement of a surface resistance

A coating film obtained in Examples and Comparative Examples each was left in an air-conditioned room at a temperature of 20 ± 2°C and at a relative humidity of 50 ± 5% for 16 hours or longer, and measured for the surface resistance of the coating film after the being left as measured at an applied voltage of 200 V by using a Digital Electro Meter 8252 and Resistivy Chamber 1270A, made by ADC Corp.

(8) Appearance

Test plates obtained in Examples and Comparative Examples each was evaluated for the appearance as follows.

(Appearance evaluation criteria)

excellent: no interference fringes
good: few interference fringes
poor: many interference fringes

[Synthesis Example 1]

Synthesis water dispersion of polymer emulsion particles (B-1)

In a reactor having a reflux cooler, a dropping tank, a thermometer and a stirrer, 1,600 g of ion-exchange water and 7 g of dodecylbenzenesulfonic acid were placed, and heated at 80°C under stirring to thereby obtain a mixed liquid (1). A mixed liquid (2) of 185 g of dimethyldimethoxysilane and 117 g of phenyltrimethoxysilane was dropped in the obtained mixed liquid (1) over about 2 hours in such a state that the temperature in the reactor was held at 80°C to thereby obtain a mixed liquid (3). Thereafter, the mixed liquid (3) was stirred for about 1 hour in such a state that the temperature in the reactor was 80°C. Then, a mixed liquid (4) of 150 g of butyl acrylate, 30 g of tetraethoxysilane, 145 g of phenyltrimethoxysilane and 1.3 g of 3-methacryloxypropyltrimethoxysilane and a mixed liquid (5) of 165 g of diethylacrylamide, 3 g of acrylic acid, 13 g of a reactive emulsifying agent (trade name: "Adeka Reasoap SR-1025", made by Adeka Corp., an aqueous solution of a solid content of 25% by mass), 40 g of an aqueous solution of 2% by mass of ammonium persulfate, and 1,900 g of ion-exchange water were simultaneously dropped in the obtained mixed liquid (3) over about 2 hours in such a state that the temperature in the reactor was held at 80°C to thereby obtain a mixture (6). The mixture (6) was further stirred, as heat aging, for about 2 hours in such a state that the temperature in the reactor was 80°C. Thereafter, the mixture (6) was cooled to room temperature, and filtered with a 100-mesh wire gauze to thereby obtain a water dispersion (solid content: 14.09% by mass) of a polymer emulsion particles (B-1) having a number-average particle diameter of 87 nm.
In the present Example, the number-average particle diameter of the polymer emulsion particles was measured by a dynamic light scattering particle size distribution analyzer.

[Example 1]

In 80 g of a 20%-ethanol aqueous solution, 1.8 g of the water dispersion of the polymer emulsion particles (B-1) synthesized in Synthesis Example 1 as a polymer emulsion particle (B), 2.5 g of a water dispersion colloidal silica having an average particle diameter of 5 nm (trade name: "Snowtex OXS", made by Nissan Chemical Industries, Ltd., solid content: 10% by mass) as a raw material of a spherical metal oxide (a1), 12.0 g of an aqueous dispersion of a rosary-like silica (trade name: "Snowtex OUP", made by Nissan Chemical Industries, Ltd., solid content: 15% by weight) which was constituted of silica primary particles having an average diameter of about 12 nm, and which had an average major diameter of about 70 nm, and mostly had an aspect ratio (major diameter/minor diameter) in the range of 3 to 25 as a raw material of a chain metal oxide (a2), and 1.7 g of tetraethoxysilane (made by Shin-Etsu Chemical Co., Ltd.) as a hydrolyzable silicon compound (C) were mixed and stirred to thereby obtain a coating composition (E-1).

The coating composition (E-1) was applied on a substrate (colorless plate glass of 5 cm × 5 cm) by using a spin coater so that the film thickness became 100 nm, and thereafter dried at 70°C for 30 min to thereby obtain a test plate (G-1) having a coating film (F-1). The compositional ratio (the same as the weight ratio of each component calculated in terms of solid content of the coating composition) in the coating film (F-1) at this time was:

(a1):(a2):(B'):(C') = 100:720:100:190.

In the present Example, (B') was the polymer particle originated from the polymer emulsion particle (B), and (C') was the hydrolytic condensation product of the hydrolyzable silicon compound (C).

The obtained test plate (G-1) had a total light transmittance of 94.6%, and the original substrate had a total light transmittance of 91.6%; therefore, the transmittance increasing rate (hereinafter, also referred to as "AR") represented by the following expression (6) was 3.3%. The test plate (G-1) had an average reflectance at wavelengths of 450 to 650 nm of 0.60%, thus exhibiting a very good antireflection property. Further the coating film (F-1) had a pencil hardness of 7H, exhibiting a very good hardness. Still further the coating film (F-1) had a contact angle with water of 10° or smaller, and a surface resistance of $3.3 \times 10^{11}\ \Omega$, exhibiting a very good antifouling property. Further, the test plate (G-1) after the weather resistance test had a total light transmittance of 94.2%, and the original substrate had a total light transmittance of 91.6%; therefore, AR after the weather resistance test was 2.8%. Therefore, the test plate (G-1) had an AR variation rate represented by the expression (7) of - 14.5%, thus exhibiting a good weather resistance.

[Expression 1]

$$AR = 100 \times \frac{\text{a total light transmittance of a test plate (coated substrate)}}{\text{a total light transmittance of the original substrate}} - 100 \quad (6)$$

[Expression 2]

$$AR \text{ variation rate} = 100 \times \frac{\text{AR after the weather resistance test}}{\text{an initial AR}} - 100 \quad (7)$$

[Example 2]

In 80 g of a 20%-ethanol aqueous solution, 1.8 g of the water dispersion of the polymer emulsion particles (B-1) synthesized in Synthesis Example 1 as a polymer emulsion particle (B), 0.6 g of a water dispersion colloidal silica having an average particle diameter of 25 nm (trade name: "Snowtex 040", made by Nissan Chemical Industries, Ltd., solid content: 40% by mass) as a raw material of a spherical metal oxide (a1), 12,0 g of an aqueous dispersion of a rosary-like silica (trade name: "Snowtex OUP", made by Nissan Chemical Industries, Ltd., solid content: 15% by weight) which was constituted of silica primary particles having an average diameter of about 12 nm, and which had an average major diameter of about 70 nm, and mostly had an aspect ratio (major diameter/minor diameter) in the range of 3 to 25 as a raw material of a chain metal oxide (a2), and 1.7 g of tetraethoxysilane (made by Shin-Etsu Chemical Co., Ltd.) as a hydrolyzable silicon compound (C) were mixed and stirred to thereby obtain a coating composition (E-2).

A test plate (G-2) having a coating film (F-2) was obtained as in Example 1, except for using the coating composition (E-2) in place of the coating composition (E-1). The compositional ratio (the same as the weight ratio of each component calculated in terms of solid content of the coating composition) in the coating film (F-2) at this time was:

(a1):(a2):(B'):(C') = 100:720:100:190.

The obtained test plate (G-2) had a total light transmittance of 94.5%, a transmittance increasing rate (AR) of 3.2%, and further an average reflectance of 0.62%, thus exhibiting a very good antireflection property. Further the coating film (F-2) had a pencil hardness of 5H, exhibiting a good hardness. Still further the coating film (F-2) had a contact angle with water of 10° or smaller, and a surface resistance of $4.1 \times 10^{11}\ \Omega$, exhibiting a very good antifouling property. Further, the test plate (G-2) after the weather resistance test had a total light transmittance of 94.3%, and an AR after the weather resistance test of 2.9%. Therefore, the test plate (G-2) had an AR variation rate after the weather resistance test of -8.4%, thus exhibiting a good weather resistance.

[Example 3]

A coating composition (E-3) was obtained and a test plate (G-3) having a coating film (F-3) was obtained by the similar methods as in Example 1, except for so adjusting the amounts of raw materials that the compositional ratio (the same as the weight ratio of each component calculated in terms of solid content of the coating composition) in the coating film (F-3) became (a1):(a2):(B'):(C') = 63:438:100:120.
The obtained test plate (G-3) had a total light transmittance of 94.6%, a transmittance increasing rate (AR) of 3.3%, and further an average reflectance of 0.63%, thus exhibiting a very good antireflection property. Further the coating film (F-3) had a pencil hardness of 6H, exhibiting a very good hardness. Still further the coating film (F-3) had a contact angle with water of 10° or smaller, and a surface resistance of $5.7 \times 10^{11}\ \Omega$, exhibiting a very good antifouling property. Further, the test plate (G-3) after the weather resistance test had a total light transmittance of 94.3%, and an AR after the weather resistance test of 3.0%. Therefore, the test plate (G-3) further had an AR variation rate after the weather resistance test of -9.9%, thus exhibiting a good weather resistance.

[Example 4]

A coating composition (E-4) was obtained and a test plate (G-4) having a coating film (F-4) was obtained by the similar methods as in Example 3, except for using an acryl latex water dispersion (trade name: "Polydurex G633", made by Asahi Kasei Chemicals Corp., solid content: 46%) (B-2) as a polymer emulsion particle (B). The compositional ratio (the same as the weight ratio of each component calculated in terms of solid content of the coating composition) of the coating film (F-4) at this time became (a1):(a2):(B'):(C') = 63:438:100:120.
The obtained test plate (G-4) had a total light transmittance of 94.3%, a transmittance increasing rate (AR) of 2.9%, and further an average reflectance of 0.95%, thus exhibiting a very good antireflection property. Further the coating film (F-4) had a pencil hardness of 6H, exhibiting a very good hardness. Still further the coating film (F-4) had a contact angle with water of 28°, and a surface resistance of $7.5 \times 10^{11}\ \Omega$, exhibiting a good antifouling property. Further, the test plate (G-4) after the weather resistance test had a total light transmittance of 93.5%, and an AR after the weather resistance test of 2.1%. Therefore, the test plate (G-4) had an AR variation rate after the weather resistance test of -28.8%, thus exhibiting a good weather resistance.

[Example 5]

A coating composition (E-5) was obtained and a test plate (G-5) having a coating film (F-5) was obtained by the similar methods as in Example 1, except for so adjusting the amounts of raw materials that the compositional ratio (the same as the weight ratio of each component calculated in terms of solid content of the coating composition) in the coating film (F-5) became (a1):(a2):(B'):(C') = 38:263:100:80.
The obtained test plate (G-5) had a total light transmittance of 94.4%, a transmittance increasing rate (AR) of 3.1%, and further an average reflectance of 0.85%, thus exhibiting a very good antireflection property. Further the coating film (F-5) had a pencil hardness of 6H, exhibiting a very good hardness. Still further the coating film (F-5) had a contact angle with water of 10° or smaller, and a surface resistance of $5.1 \times 10^{11}\ \Omega$, exhibiting a very good antifouling property. Further, the test plate (G-5) after the weather resistance test had a total light transmittance of 94.3%, and an AR after the weather resistance test of 2.9%. Therefore, the test plate (G-5) had an AR variation rate of the weather resistance of -4.5%, thus exhibiting a good weather resistance.

[Example 6]

A coating composition (E-6) was obtained and a test plate (G-6) having a coating film (F-6) was obtained by the similar methods as in Example 1, except for so adjusting the amounts of raw materials that the compositional ratio (the same as the weight ratio of each component calculated in terms of solid content of the coating composition) in the coating film (F-6) became (a1):(a2):(B'):(C') = 25:175:100:60.
The obtained test plate (G-6) had a total light transmittance of 94.3%, a transmittance increasing rate (AR) of 2.9%, and further an average reflectance of 0.92%, thus exhibiting a very good antireflection property. Further the coating film (F-6) had a pencil hardness of 5H, exhibiting a good hardness. Still further the coating film (F-6) had a contact angle with water of 10°, and a surface resistance of $6.3 \times 10^{11}\ \Omega$, exhibiting a very good antifouling property. Further, the test plate (G-6) after the weather resistance test had a total light transmittance of 94.2%, and an AR after the weather resistance test of 2.9%. Therefore, the test plate (G-6) had an AR variation rate after the weather resistance test of -3.3%, thus exhibiting a very good weather resistance.

[Example 7]

A coating composition (E-7) was obtained and a test plate (G-7) having a coating film (F-7) was obtained by the similar methods as in Example 1, except for so adjusting the amounts of raw materials that the compositional ratio (the same as the weight ratio of each component calculated in terms of solid content of the coating composition) in the coating film (F-7) became (a1):(a2):(B'):(C') = 13:88:100:40.

The obtained test plate (G-7) had a total light transmittance of 93.5%, a transmittance increasing rate (AR) of 2.1%, and further an average reflectance of 1.25%, thus exhibiting a good antireflection property. Further the coating film (F-7) had a pencil hardness of 4H, exhibiting a good hardness. Still further the coating film (F-7) had a contact angle with water of 25°, and a surface resistance of $6.5 \times 10^{11} \, \Omega$, exhibiting a good antifouling property. Further, the test plate (G-7) after the weather resistance test had a total light transmittance of 93.5%, and an AR after the weather resistance test of 2.1%. Therefore, the test plate (G-7) had an AR variation rate after the weather resistance test of -1.2%, thus exhibiting a very good weather resistance.

[Example 8]

A coating composition (E-8) was obtained and a test plate (G-8) having a coating film (F-8) was obtained by the similar methods as in Example 1, except for so adjusting the amounts of raw materials that the compositional ratio (the same as the weight ratio of each component calculated in terms of solid content of the coating composition) in the coating film (F-8) became (a1):(a2):(B'):(C') = 125:875:100:221.

The obtained test plate (G-8) had a total light transmittance of 94.5%, a transmittance increasing rate (AR) of 3.2%, and further an average reflectance of 0.67%, thus exhibiting a very good antireflection property. Further the coating film (F-8) had a pencil hardness of 7H, exhibiting a very good hardness. Still further the coating film (F-8) had a contact angle with water of 10° or smaller, and a surface resistance of $3.1 \times 10^{11} \, \Omega$, exhibiting a very good antifouling property. Further, the test plate (G-8) after the weather resistance test had a total light transmittance of 93.9%, and an AR after the weather resistance test of 2.5%. Therefore, the test plate (G-8) had an AR variation rate after the weather resistance test of -21.0%, thus exhibiting a good weather resistance.

[Example 9]

A coating composition (E-9) was obtained and a test plate (G-9) having a coating film (F-9) was obtained by the similar methods as in Example 1, except for so adjusting the amounts of raw materials that the compositional ratio (the same as the weight ratio of each component calculated in terms of solid content of the coating composition) in the coating film (F-9) became (a1):(a2):(B'):(C') = 188:1313:100:321.

The obtained test plate (G-9) had a total light transmittance of 94.4%, a transmittance increasing rate (AR) of 3.1%, and further an average reflectance of 0.72%, thus exhibiting a very good antireflection property. Further the coating film (F-9) had a pencil hardness of 7H, exhibiting a very good hardness. Still further the coating film (F-9) had a contact angle with water of 10° or smaller, and a surface resistance of $2.8 \times 10^{11} \, \Omega$, exhibiting a very good antifouling property. Further, the test plate (G-9) after the weather resistance test had a total light transmittance of 93.7%, and an AR after the weather resistance test of 2.3%. Therefore, the test plate (G-9) had an AR variation rate after the weather resistance test of -24.8%, thus exhibiting a good weather resistance.

[Example 10]

A coating composition (E-10) was obtained and a test plate (G-10) having a coating film (F-10) was obtained by the similar methods as in Example 1, except for so adjusting the amounts of raw materials that the compositional ratio (the same as the weight ratio of each component calculated in terms of solid content of the coating composition) in the coating film (F-10) became (a1):(a2):(B'):(C') = 250:1750:100:421.

The obtained test plate (G-10) had a total light transmittance of 94.6%, a transmittance increasing rate (AR) of 3.3%, and further an average reflectance of 0.61%, thus exhibiting a very good antireflection property. Further the coating film (F-10) had a pencil hardness of 7H, exhibiting a very good hardness. Still further the coating film (F-10) had a contact angle with water of 10° or smaller, and a surface resistance of $2.5 \times 10^{11} \, \Omega$, exhibiting a very good antifouling property. Further, the test plate (G-10) after the weather resistance test had a total light transmittance of 93.7%, and an AR after the weather resistance test of 2.3%. Therefore, the test plate (G-10) had an AR variation rate after the weather resistance test of -29.8%, thus exhibiting a good weather resistance.

[Example 11]

A coating composition (E-11) was obtained and a test plate (G-11) having a coating film (F-11) was obtained by the similar methods as in Example 1, except for so adjusting the amounts of raw materials that the compositional ratio (the same as the weight ratio of each component calculated in terms of solid content of the coating composition) in the coating film (F-11) became (a1):(a2):(B'):(C') = 63:438:100:257.

The obtained test plate (G-11) had a total light transmittance of 93.7%, a transmittance increasing rate (AR) of 2.3%, and further an average reflectance of 1.45%, thus exhibiting a good antireflection property. Further the coating film (F-11) had a pencil hardness of 8H, exhibiting a very good hardness. Still further the coating film (F-11) had a contact angle with water of 10° or smaller, and a surface resistance of $6.1 \times 10^{11}\ \Omega$, exhibiting a very good antifouling property. Further, the test plate (G-11) after the weather resistance test had a total light transmittance of 93.5%, and an AR after the weather resistance test of 2.1%. Therefore, the test plate (G-11) had an AR variation rate after the weather resistance test of -8.4%, thus exhibiting a good weather resistance.

[Example 12]

A coating composition (E-12) was obtained and a test plate (G-12) having a coating film (F-12) was obtained by the similar methods as in Example 1, except for so adjusting the amounts of raw materials that the compositional ratio (the same as the weight ratio of each component calculated in terms of solid content of the coating composition) of the coating film (F-12) became (a1):(a2):(B'):(C') = 63:438:100:67, and further adding hydrochloric acid of 0.2% by weight to the amount of the raw materials.

The obtained test plate (G-12) had a total light transmittance of 94.7%, a transmittance increasing rate (AR) of 3.4%, and further an average reflectance of 0.58%, thus exhibiting a very good antireflection property. Further the coating film (F-12) had a pencil hardness of 4H, exhibiting a good hardness. Still further the coating film (F-12) had a contact angle with water of 10° or smaller, and a surface resistance of $6.9 \times 10^{11}\ \Omega$, exhibiting a very good antifouling property. Further, the test plate (G-12) after the weather resistance test had a total light transmittance of 94.3%, and an AR after the weather resistance test of 2.9%. Therefore, the test plate (G-12) had an AR variation rate after the weather resistance test of -14.3%, thus exhibiting a good weather resistance.

[Example 13]: a comparative example

A coating composition (E-13) was obtained and a test plate (G-13) having a coating film (F-13) was obtained by the similar methods as in Example 1, except for using no hydrolyzable silicon compound (C) and so adjusting the amounts of raw materials that the compositional ratio (the same as the weight ratio of each component calculated in terms of solid content of the coating composition) of the coating film (F-13) became (a1):(a2):(B'):(C') = 500:500:100:0.

The obtained test plate (G-13) had a total light transmittance of 93.7%, a transmittance increasing rate (AR) of 2.3%, and further an average reflectance of 1.42%, thus exhibiting a good antireflection property. Further the coating film (F-13) had a pencil hardness of 3H, exhibiting a good hardness. Still further the coating film (F-13) had a contact angle with water of 10° or smaller, and a surface resistance of $6.7 \times 10^{11}\ \Omega$, exhibiting a very good antifouling property. Further, the test plate (G-13) after the weather resistance test had a total light transmittance of 93.4%, and an AR after the weather resistance test of 2.0%. Therefore, the test plate (G-13) had an AR variation rate after the weather resistance test of -12.2%, thus exhibiting a good weather resistance.

[Comparative Example 1]

In 80 g of a 20%-ethanol aqueous solution, 1.8 g of the water dispersion of the polymer emulsion particles (B-1) synthesized in Synthesis Example 1, 20 g of a water dispersion colloidal silica having an average particle diameter of 5 nm (trade name: "Snowtex OXS", made by Nissan Chemical Industries, Ltd., solid content: 10% by mass), and 1.7 g of tetraethoxysilane (made by Shin-Etsu Chemical Co., Ltd.) were mixed and stirred to thereby obtain a coating composition (E-c1).

The coating composition (E-c1) was applied on a substrate (colorless plate glass of 5 cm $\times$ 5 cm) by using a spin coater so that the film thickness became 100 nm, and thereafter dried at 70°C for 30 min to thereby obtain a test plate (G-c1) having a coating film (F-c1). The compositional ratio (the same as the weight ratio of each component calculated in terms of solid content of the coating composition) of the coating film (F-c1) at this time was:

(a1):(a2):(B'):(C') = 200:0:100:180.

The obtained test plate (G-c1) had a total light transmittance of 93.0% and a transmittance increasing rate (AR) of 1.5%, and further an average reflectance of 2.82%, exhibiting a low antireflection property.

[Comparative Example 2]

In 80 g of a 20%-ethanol aqueous solution, 1.8 g of the water dispersion of the polymer emulsion particles (B-1) synthesized in Synthesis Example 1, 13.3 g of an aqueous dispersion of a rosary-like silica (trade name: "Snowtex OUP", made by Nissan Chemical Industries, Ltd., solid content: 15% by weight) which was constituted of silica primary particles having an average diameter of about 12 nm, and which had an average major diameter of about 70 nm, and had an average aspect ratio of about 5.8 (the most particles had an aspect ratio (major diameter/minor diameter) in the range of 3 to 25), and 1.7 g of tetraethoxysilane (made by Shin-Etsu Chemical Co., Ltd.) were mixed and stirred to thereby obtain a coating composition (E-c2).

The coating composition (E-c2) was applied on a substrate (colorless plate glass of 5 cm × 5 cm) by using a spin coater so that the film thickness became 100 nm, and thereafter dried at 70°C for 30 min to thereby obtain a test plate (G-c2) having a coating film (F-c2). The compositional ratio (the same as the weight ratio of each component calculated in terms of solid content of the coating composition) of the coating film (F-c2) at this time was:

(a1):(a2):(B'):(C') = 0:800:100:180.

The obtained coating film (F-c2) had a pencil hardness of 3B, exhibiting a low hardness.

[Comparative Example 3]

A coating composition (E-c3) was obtained and a test plate (G-c3) having a coating film (F-c3) was obtained by the similar methods as in Example 3, except for using a polyvinyl alcohol (made by Wako Pure Chemical Industries, Ltd., the degree of polymerization: about 1,000)(PVA1000) in place of the polymer emulsion particles (B). The compositional ratio (the same as the weight ratio of each component calculated in terms of solid content of the coating composition) of the coating film (F-c3) at this time became (a1):(a2):(B''):(C') = 63:438:100:120.

Here, (B'') represents the polyvinyl alcohol.

The obtained coating film (F-c3) had a pencil hardness of H, exhibiting a low hardness. The test plate (G-c3) had an AR variation rate after the weather resistance test of -37.0%, exhibiting a low weather resistance. As a result of the observation of the cross-section of the obtained coating film (F-c3) by TEM (S550 made by Hitachi Ltd., applied voltage: 30 kV), there were parts where the polyvinyl alcohols (B'') themselves were present in direct contact with one another.

[Comparative Example 4]

A coating composition (E-c4) was obtained and a test plate (G-c4) having a coating film (F-c4) was obtained by the similar methods as in Example 1, except for using no polymer emulsion particles (B) and so adjusting the amounts of raw materials that the compositional ratio (the same as the weight ratio of each component calculated in terms of solid content of the coating composition) of the coating film (F-c4) became (a1):(a2):(B'):(C') = 63:438:0:100.

The obtained test plate (G-c4) had an AR variation rate after the weather resistance test of -49.8%, exhibiting a low weather resistance. The test plate (G-c4) had large film thickness unevenness, exhibiting poor appearance.

The results of the Examples and the Comparative Examples are shown in Table 1.

[Table 1]

|  | Average Reflectance (%) | Transmittance (%) | AR (%) | Haze (%) | Pencil Hardness | Water Contact Angle (°) | Surface Resistance (Ω) | Appearance | AR Variation Rate After Weather Resistance Test (%) |
|---|---|---|---|---|---|---|---|---|---|
| Example 1 | 0.60 | 94.6 | 3.3 | 0.20 | 7H | <10 | 3.3x10^11 | excellent | -14.5 |
| Example 2 | 0.62 | 94.5 | 3.2 | 0.24 | 5H | <10 | 4.1x10^11 | excellent | -8.4 |
| Example 3 | 0.63 | 94.6 | 3.3 | 0.30 | 6H | <10 | 5.7x10^11 | excellent | -9.9 |
| Example 4 | 0.95 | 94.3 | 2.9 | 0.32 | 6H | 28 | 7.5×10^11 | excellent | -28.8 |
| Example 5 | 0.85 | 94.4 | 3.1 | 0.35 | 6H | <10 | 5.1×10^11 | good | -4.5 |
| Example 6 | 0.92 | 94.3 | 2.9 | 0.45 | 5H | 10 | 6.3×10^11 | good | -3.3 |
| Example 7 | 1.25 | 93.5 | 2.1 | 1.30 | 4H | 25 | 6.5×10^11 | good | -1.2 |
| Example 8 | 0.67 | 94.5 | 3.2 | 0.15 | 7H | <10 | 3.1×10^11 | excellent | -21.0 |
| Example 9 | 0.72 | 94.4 | 3.1 | 0.17 | 7H | <10 | 2.8×10^11 | good | -24.8 |
| Example 10 | 0.61 | 94.6 | 3.3 | 0.16 | 7H | <10 | 2.5×10^11 | good | -29.8 |
| Example 11 | 1.45 | 93.7 | 2.3 | 0.16 | 8H | <10 | 6.1×10^11 | excellent | -8.4 |
| Example 12 | 0.58 | 94.7 | 3.4, | 0.16 | 4H | <10 | 6.9×10^11 | excellent | -14.3 |
| Example 13 | 1.42 | 93.7 | 2.3 | 0.20 | 3H | <10 | 6.7×10^11 | excellent | -12.2 |
| Comparative Example 1 | 2.82 | 93.0 | 1.5 | 0.40 | 7H | <10 | - | excellent | -2.5 |
| Comparative Example 2 | 0.55 | 94.8 | 3.5 | 0.65 | 3B | <10 | - | good | -17.0 |
| Comparative Example 3 | 1.29 | 94.0 | 2.6 | 0.25 | H | <10 | - | excellent | -37.0 |
| Comparative Example 4 | 0.65 | 94.5 | 3.2 | 0.20 | 7H | <10 | - | poor | -49.8 |
| Colorless Glass Substrate | 4.40 | 91.6 | - | 0.05 | - | 35 | 5.0×10^14 | - | - |

EP 2 808 368 B1

As shown in Table 1, a test plate having a coating film in each Example exhibited a very good antireflection effect and a very good mechanical strength of the coating film. By contrast, it was confirmed that Comparative Example 1, though being excellent in the mechanical strength of the coating film, had a small antireflection effect. It was also confirmed that Comparative Example 2, though being excellent in the antireflection effect, had a low mechanical strength of the coating film. It was confirmed that Comparative Example 3, though being excellent in the antireflection effect, had a low mechanical strength of the coating film, and further had a low weather resistance. It was confirmed that Comparative Example 4, though being excellent in the antireflection effect, and in the mechanical strength of the coating film, had a low weather resistance.

It was confirmed that coating films of Examples and Comparative Examples containing both of metal oxides (A) and a hydrolyzable silicon compound (C) had good wettability to water, and exhibited little electrostatic adhesion of dusts, exhibiting a large antifouling effect.

As a result of the observation of the cross-section of a coating film obtained in each Example by TEM (S550, made by Hitachi Ltd., applied voltage: 30 kV), it was confirmed that the polymer particles (B') themselves were present in no direct contact with one another. Further as a result of the observation of the cross-section of the coating film obtained in each Example by a scanning electron microscope (SEM), it was confirmed that the coating film had a structural body in which a chain metal oxide (a2) was bonded directly, and/or through a spherical metal oxide (a1), to the surface of the polymer particle (B'), and in the case where the coating film comprises a hydrolytic condensation product (C'), the coating film had a structural body in which the hydrolytic condensation product (C') was bonded to the surface of the polymer particle (B'). In detail, it was confirmed by SEM that a coating film obtained in each Example had a structural body in which the chain metal oxide (a2) was bonded to hydrogen-bondable functional groups of the polymer particle (B'). Still further as a result of the observation of the cross-section of the coating film obtained in each Example by a scanning electron microscope (SEM), it was confirmed that the metal oxides (A) and/or the hydrolytic condensation product (C') of the hydrolyzable silicon compound (C) was bonded directly to the substrate. That is, it is conceivable that silanols of the substrate (glass) surface and silanols of the metal oxides (A) (silica) or of the hydrolytic condensation product (C') were condensed.

Industrial Applicability

The coating composition according to the present invention can suitably be used to manufacture an antireflection film of members, such as of solar cells, photovoltaic cells, liquid crystal display, eyeglasses, window glasses and televisions, needing the improvement of the light transmission and/or the prevention of the reflection, and an antifouling coat of the members.

**Claims**

1. A coating composition, comprising:

   a metal oxide (A) containing a spherical metal oxide (a1) and a chain metal oxide (a2) having an aspect ratio (major diameter/minor diameter) of 3 to 25; and
   a polymer emulsion particle (B),

   wherein the spherical metal oxide (a1) has an average particle diameter of 1 to 50 nm; and
   the weight ratio of the spherical metal oxide (a1) and the chain metal oxide (a2) ((a1):(a2)) is 1:3 to 1:20.

2. The coating composition according to claim 1, further comprising a hydrolyzable silicon compound (C).

3. The coating composition according to claim 1 or 2,
   wherein the chain metal oxide (a2) has an average major diameter of 20 to 250 nm.

4. The coating composition according to claim 2 or 3, wherein the weight ratio of the metal oxide (A) and the polymer emulsion particle (B) ((A):(B)) is 1:0.05 to 1:1; and the weight ratio of the metal oxide (A) and the hydrolyzable silicon compound (C) ((A):(C)) is 1:0.05 to 1:0.5.

5. The coating composition according to any one of claims 1 to 4, wherein the polymer emulsion particle (B) is obtained by polymerizing a hydrolyzable silicon compound (b1) and a vinyl monomer (b2) having a secondary and/or tertiary amido group in the presence of water and an emulsifying agent.

6. An antireflection film, being obtained by applying and drying the coating composition according to any one of claims 1 to 5 on a substrate.

7. The antireflection film according to claim 6 comprising polymer particles (B'), wherein the polymer particles (B') themselves are present in no direct contact with one another.

8. The antireflection film according to claim 7, wherein the antireflection film has a structural body in which the chain metal oxide (a2) is bonded directly, and/or through the spherical metal oxide (a1), to a surface of the polymer particle (B').

9. The antireflection film according to claim 7 or 8, further comprising a hydrolytic condensation product (C') of a hydrolyzable silicon compound (C),
   wherein the antireflection film has a structural body in which the hydrolytic condensation product (C') of the hydrolyzable silicon compound (C) is bonded to a surface of the polymer particle (B'); and further, the chain metal oxide (a2) is bonded directly, and/or through the spherical metal oxide (a1), to a surface of the polymer particle (B').

10. The antireflection film according to any one of claims 7 to 9, wherein the polymer particle (B') has at least one hydrogen-bondable functional group selected from the group consisting of an amido group, an ether group, a hydroxyl group, a thiol group and a carbonyl group; and
    the antireflection film has a structural body in which the chain metal oxide (a2) is bonded to the hydrogen-bondable functional group of the polymer particle (B').

11. The antireflection film according to any one of claims 7 to 10,
    wherein the antireflection film is formed on a substrate; and
    the metal oxide (A) and/or the hydrolytic condensation product (C') of the hydrolyzable silicon compound (C) is bonded directly to the substrate.

12. The antireflection film according to any one of claims 7 to 11, wherein the antireflection film has a contact angle with water of 40° or smaller.

13. The antireflection film according to any one of claims 7 to 12, wherein the antireflection film has a surface resistance of $1.0 \times 10^{14}\,\Omega$ or lower, the surface resistance being measured at an applied voltage of 200 V after the antireflection film is left in an air-conditioned room at a temperature of $20 \pm 2$°C and at a relative humidity of $50 \pm 5$% for 16 hours or longer.

14. A method for manufacturing a coating composition, comprising:

    a first step of blending a metal oxide (A) containing a spherical metal oxide (a1) and a chain metal oxide (a2) having an aspect ratio of 3 to 25, and a polymer emulsion particle (B) to thereby obtain a mixture; and
    a second step of adding an acid to the mixture obtained in the first step,
    wherein the spherical metal oxide (a1) has an average particle diameter of 1 to 50 nm; and the weight ratio of the spherical metal oxide (a1) and the chain metal oxide (a2) ((a1):(a2)) is 1:3 to 1:20.

15. A glass for a solar cell, comprising the antireflection film according to any one of claims 6 to 13.

16. A module for a solar cell, comprising the antireflection film according to any one of claims 6 to 13.

17. A condenser lens for a solar cell, comprising the antireflection film according to any one of claims 6 to 13.

**Patentansprüche**

1. Beschichtungszusammensetzung, enthaltend:

   ein Metalloxid (A), welches ein kugelförmiges Metalloxid (a1) und ein kettenförmiges Metalloxid (a2) mit einem Aspektverhältnis (größter Durchmesser/kleinster Durchmesser) von 3 bis 25; und
   ein Polymeremulsionsteilchen (B),
   wobei das kugelförmige Metalloxid (a1) einen mittleren Teilchendurchmesser von 1 bis 50 nm aufweist; und

das Gewichtsverhältnis des kugelförmigen Metalloxids (a1) und des kettenförmigen Metalloxids ((a1):(a2)) 1:3 bis 1:20 ist.

2. Beschichtungszusammensetzung nach Anspruch 1,
welche weiterhin eine hydrolysierbare Siliciumverbindung (C) enthält.

3. Beschichtungszusammensetzung nach Anspruch 1 oder 2,
wobei das kettenförmige Metalloxid (a2) einen mittleren längsten Durchmesser von 20 bis 250 nm aufweist.

4. Beschichtungszusammensetzung nach Anspruch 2 oder 3,
wobei das Gewichtsverhältnis des Metalloxids (A) und des Polymeremulsionsteilchens (B) ((A):(B)) 1:0,05 bis 1:1 ist; und
das Gewichtsverhältnis des Metalloxids (A) und der hydrolysierbaren Siliciumverbindung (C) ((A):(C)) 1:0,05 bis 1:0,5 ist.

5. Beschichtungszusammensetzung nach einem der Ansprüche 1 bis 4, wobei das Polymeremulsionsteilchen (B) durch Polymerisieren einer hydrolysierbaren Siliciumverbindung (b1) und eines Vinylmonomers (b2), das eine sekundäre und/oder tertiäre Aminogruppe aufweist, in Gegenwart von Wasser und einem Emulgiermittel erhalten wird.

6. Antireflexionsfilm, welcher durch Aufbringen und Trocknen der Beschichtungszusammensetzung nach einem der Ansprüche 1 bis 5 auf ein Substrat erhalten wird.

7. Antireflexionsfilm nach Anspruch 6, welcher Polymerteilchen (B') enthält, wobei die Polymerteilchen (B') selbst in keinem direkten Kontakt miteinander vorliegen.

8. Antireflexionsfilm nach Anspruch 7, wobei der Antireflexionsfilm einen Strukturkörper aufweist, bei dem das kettenförmige Metalloxid (a2) direkt und/oder über das kugelförmige Metalloxid (a1) an eine Oberfläche des Polymerteilchens (B') gebunden ist.

9. Antireflexionsfilm nach Anspruch 7 oder 8, weiterhin enthaltend ein Produkt einer hydrolytischen Kondensation (C') einer hydrolysierbaren Siliciumverbindung (C),
wobei der Antireflexionsfilm einen Strukturkörper aufweist, bei dem das Produkt der hydrolytischen Kondensation (C') der hydrolysierbaren Siliciumverbindung (C) an eine Oberfläche des Polymerteilchens (B') gebuden ist; und weiterhin das kettenförmige Metalloxid (a2) direkt und/oder über das kugelförmige Metalloxid (a1) an eine Oberfläche des Polymerteilchens (B') gebunden ist.

10. Antireflexionsfilm nach einem der Ansprüche 7 bis 9, wobei das Polymerteilchen (B') mindestens eine an Wasserstoff bindungsfähige funktionale Gruppe aufweist, die aus der Gruppe ausgewählt ist, bestehend aus eine Amidogruppe, einer Ethergruppe, einer Hydroxygruppe, einer Thiolgruppe und einer Carbonylgruppe; und der Antireflexionsfilm einen Strukturkörper aufweist, bei dem das kettenförmige Metalloxid (a2) an die an Wasserstoff bindungsfähige funktionale Gruppe des Polymerteilchens (B') gebunden ist.

11. Antireflexionsfilm nach einem der Ansprüche 7 bis 10,
wobei der Antireflexionsfilm auf einem Substrat gebildet ist; und
das Metalloxid (A) und/oder das Produkt der hydrolytischen Kondensation (C') der hydrolysierbaren Siliciumverbindung (C) direkt an das Substrat gebunden ist.

12. Antireflexionsfilm nach einem der Ansprüche 7 bis 11,
wobei der Antireflexionsfilm einen Kontaktwinkel mit Wasser von 40° oder kleiner aufweist.

13. Antireflexionsfilm nach einem der Ansprüche 7 bis 12,
wobei der Antireflexionsfilm einen Oberflächenwiderstand von $1,0 \times 10^{14}$ Ω oder weniger aufweist, wobei der Oberflächenwiderstand bei einer angelegten Spannung von 200 V gemessen wird, nachdem der Antireflexionsfilm in einem Klimaanlagen-Raum bei einer Temperatur von 20 ± 2°C und einer relativen Feuchtigkeit von 50 ± 5% für 16 Stunden oder länger stehen gelassen wurde.

14. Verfahren zur Herstellung einer Beschichtungszusammensetzung, mit den Schritten:

einem ersten Schritt, bei dem ein Metalloxid (A), welches ein kugelförmiges Metalloxid (a1) und ein kettenförmiges Metalloxid (a2) mit einem Aspektverhältnis von 3 bis 25 enthält, und ein Polymeremulsionsteilchen (B) gemischt werden, um ein Gemisch zu erhalten; und

einem zweiten Schritt, bei dem eine Säure zu dem im ersten Schritt erhaltenen Gemisch gegeben wird, wobei das kugelförmige Metalloxid (a1) einen mittleren Teilchendurchmesser von 1 bis 50 nm aufweist; und das Gewichtsverhältnis des kugelförmigen Metalloxids (a1) und des kettenförmigen Metalloxids ((a1):(a2)) 1:3 bis 1:20 ist.

**15.** Solarzellenglas, welches den Antireflexionsfilm nach einem der Ansprüche 6 bis 13 aufweist.

**16.** Solarzellenmodul, welches den Antireflexionsfilm nach einem der Ansprüche 6 bis 13 aufweist.

**17.** Kondensorlinse für eine Solarzelle, welche den Antireflexionsfilm nach einem der Ansprüche 6 bis 13 aufweist.

**Revendications**

**1.** Composition de revêtement, comprenant :*

un oxyde de métal (A) contenant un oxyde de métal sphérique (a1) et un oxyde de métal en chaîne (a2) ayant un rapport d'allongement (diamètre principal/diamètre mineur) de 3 à 25 ; et
une particule d'émulsion polymère (B),
dans laquelle l'oxyde de métal sphérique (a1) présente un diamètre moyen de particule de 1 à 50 nm ; et
le rapport massique de l'oxyde de métal sphérique (a1) et de l'oxyde de métal en chaîne (a2) ((a1):(a2)) est 1:3 à 1:20.

**2.** Composition de revêtement selon la revendication 1, comprenant de plus un composé de silicium hydrolysable (C).

**3.** Composition de revêtement selon la revendication 1 ou 2, dans laquelle l'oxyde de métal en chaîne (a2) présente un diamètre majeur moyen de 20 à 250 nm.

**4.** Composition de revêtement selon la revendication 2 ou 3, dans laquelle le rapport massique de l'oxyde de métal (A) et de la particule d'émulsion polymère ((B) (A):B)) est de 1:0,05 à 1:1 ; et
le rapport massique de l'oxyde de métal (A) et du composé de silicium hydrolysable (C) ((A) : (C)) est de 1:0,05 à 1:0,5.

**5.** Composition de revêtement selon l'une quelconque des revendications 1 à 4; dans laquelle la particule d'émulsion polymère (B) est obtenue par polymérisation d'un composé de silicium hydrolysable (b1) et d'un monomère vinyle (b2) ayant un groupe amino secondaire et/ou tertiaire en présence d'eau et d'un agent émulsionnant.

**6.** Film anti-réflexion, étant obtenu par application et séchage de la composition de revêtement selon l'une quelconque des revendications 1 à 5 sur un substrat.

**7.** Film anti-réflexion selon la revendication 6 comprenant des particules polymères (B'), dans lequel les particules polymères (B') sont elles-mêmes présentes sans contact direct les unes avec les autres.

**8.** Film anti-réflexion selon la revendication 7, dans lequel le film anti-réflexion présente un corps structurel dans lequel l'oxyde de métal en chaîne (a2) est directement lié, et/ou par l'oxyde de métal sphérique (a1), à une surface de la particule polymère (B').

**9.** Film anti-réflexion selon la revendication 7 ou 8, comprenant de plus un produit de condensation hydrolytique (C') d'un composé de silicium hydrolysable (C),
dans lequel le film anti-réflexion présente un corps structurel dans lequel le produit de condensation hydrolytique (C') du composé de silicium hydrolysable (C) est lié à une surface de la particule polymère (B') ; et de plus, l'oxyde de métal en chaîne (a2) est directement lié, et/ou par l'intermédiaire de l'oxyde de métal sphérique (a1), à une surface de la particule polymère (B').

**10.** Film anti-réflexion selon l'une quelconque des revendications è à 9, dans lequel la particule polymère (B') présente au moins un groupe fonctionnel pouvant être lié à l'hydrogène choisi dans le groupe constitué d'un groupe amido, d'un groupe éther, d'un groupe hydroxyle, d'un groupe thiol et d'un groupe carbonyle ; et
le film anti-réflexion présente un corps structurel dans lequel l'oxyde de métal en chaîne (a2) est lié au groupe fonctionnel pouvant être lié à l'hydrogène de la particule polymère (B').

11. Film anti-réflexion selon l'une quelconque des revendications 7 à 10,
dans lequel le film anti-réflexion est formé sur un substrat ; et
l'oxyde de métal (A) et/ou le produit de condensation hydrolytique (C') du composé de silicium hydrolysable (C) est directement lié au substrat.

12. Film anti-réflexion selon l'une quelconque des revendications 7 à 11, dans lequel le film anti-réflexion présente un angle de contact avec l'eau de 40° ou inférieur.

13. Film anti-réflexion selon l'une quelconque des revendications 7 à 12; dans lequel le film anti-réflexion présente une résistance de surface de $1,0 \times 10^{14}$ $\Omega$ au moins inférieure, la résistance de surface étant mesurée à une tension appliquée à 200 V après que le film anti-réflexion est laissé dans une chambre conditionnée à l'air à une température de $20 \pm 2C$ et à une humidité relative de $50 \pm 5$ % pendant 16 heures ou plus.

14. Procédé de fabrication d'une composition de revêtement, comprenant :

une première étape de combinaison d'un oxyde de métal (A) contenant un oxyde de métal sphérique (a1) et un oxyde de métal en chaîne (a2) ayant un rapport d'allongement de 3 à 25, et une particule d'émulsion polymère (B) pour obtenir par là un mélange ; et
une seconde étape d'addition d'un acide au mélange obtenu dans la première étape,
dans lequel l'oxyde de métal sphérique (a1) présente un diamètre moyen de particule de 1 à 50 nm ; et le rapport massique de l'oxyde de métal sphérique (a1) et de l'oxyde de métal en chaîne (a2) ((a1) : (a2)) est de 1:3 à 1:20.

15. Verre pour une pile photovoltaïque, comprenant le film anti-réflexion selon l'une quelconque des revendications 6 à 13.

16. Module pour une pile photovoltaïque, comprenant le film anti-réflexion selon l'une quelconque des revendications 6 à 13.

17. Lentilles de condensateur pour une pile photovoltaïque, comprenant le film anti-réflexion selon l'une quelconque des revendications 6 à 13.

EP 2 808 368 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 1312501 A
- JP 7140303 A
- JP 3199043 A
- JP 11035313 A
- JP 2001 A
- JP 188104 A
- JP 11061043 A
- JP 11292568 A
- JP 2005010470 A
- WO 2007069596 A
- WO 2011530401 A
- WO 2010104146 A
- US 2011123708 A1